# EUROPEAN PATENT APPLICATION

(11) **EP 2 549 522 A1**
(43) Date of publication of application: **23.01.2013**
(21) Application number: 11756047.4
(22) Date of filing: 25.02.2011
(51) Int. Cl.: H01L 21/205, C23C 16/455, C23C 16/458

(54) **SEMICONDUCTOR THIN-FILM MANUFACTURING METHOD, SEMINCONDUCTOR THIN-FILM MANUFACTURING APPARATUS, SUSCEPTOR, AND SUSCEPTOR HOLDING TOOL**

(30) Priority: 15.03.2010 JP 2010058023
(71) Applicant: Sumitomo Electric Industries, Ltd., Chuo-ku Osaka-shi Osaka 541-0041 (JP)
(72) Inventor: SHIOMI, Hiromu, Osaka-shi Osaka 554-0024 (JP); SENDA, Yasuhiko, Itami-shi Hyogo 664-0016 (JP); ITOH, Satomi, Osaka-shi Osaka 554-0024 (JP); FUJIKAWA, Kazuhiro, Osaka-shi Osaka 554-0024 (JP); SHIMADA, Shigeki, Osaka-shi Osaka 554-0024 (JP); GENBA, Jun, Osaka-shi Osaka 554-0024 (JP); TERAO, Takemi, Osaka-shi Osaka 554-0024 (JP); FURUSHO, Masaru, Osaka-shi Osaka 554-0024 (JP)
(74) Representative: Grünecker, Kinkeldey, Stockmair & Schwanhäusser
(86) International application number: PCT/JP2011/054272
(87) International publication number: WO 2011/114858

(57) **Abstract**

Substrates (10-12) are mounted on a plurality of susceptors (20-22) respectively, The plurality of susceptors on which respective substrates are mounted are placed on a rotational mechanism so that the susceptors are vertically spaced at a predetermined interval. The rotational mechanism on which the plurality of susceptors are placed is rotated. The plurality of susceptors on which the substrates are mounted respectively are heated. Semiconductor thin-films are deposited by supplying a source gas to each of the susceptors that are heated while being rotated, the source gas having been heated while passing through gas flow paths of respective path lengths substantially equal to each other.

## Description

### TECHNICAL FIELD

The present invention relates to a method for manufacturing a semiconductor thin-film, an apparatus for manufacturing a semiconductor thin-film, a susceptor, and a susceptor holder. In particular, the present invention relates to semiconductor thin-film manufacturing method and manufacturing apparatus based on the CVD (Chemical Vapor Deposition) method that epitaxially grows a single-crystal semiconductor thin-film on a susceptor, and further relates to the susceptor and a susceptor holder used for the manufacturing apparatus.

### BACKGROUND ART

A semiconductor substrate for which SiC (silicon carbide) is used has a higher bandgap and superior characteristics such as thermal resistance and thermal conductivity, as compared with a semiconductor substrate for which Si (silicon) is used. Thus, studies of the former semiconductor substrate are being actively conducted.

For manufacture of this semiconductor substrate made of SiC (hereinafter referred to as "SiC substrate"), a hot-wall CVD apparatus has conventionally been used.

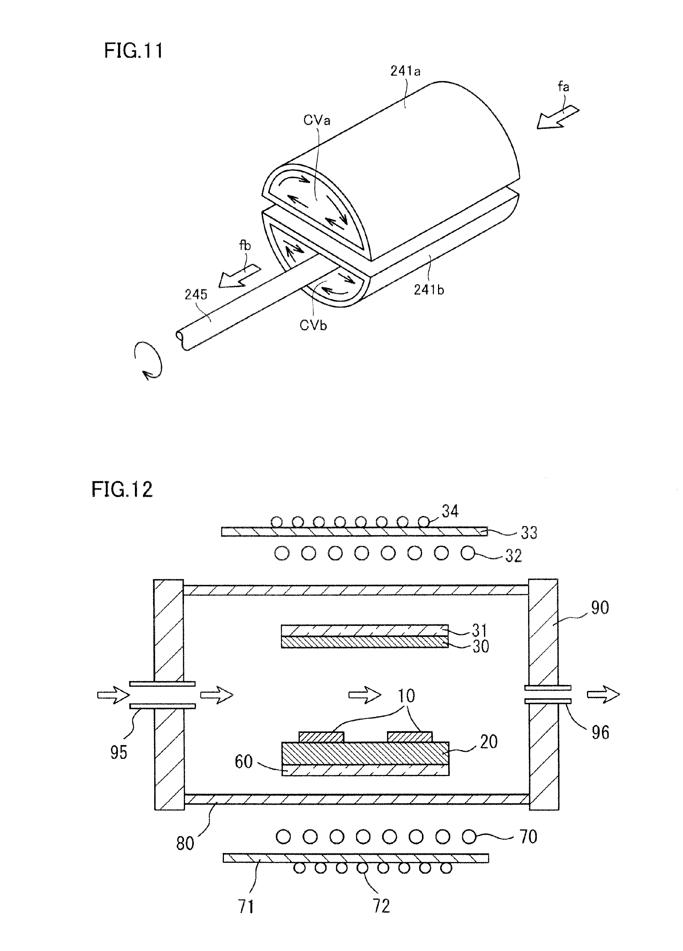

As to manufacture of an SiC substrate by means of this hot-wall CVD apparatus, a description will be given with reference to Fig. 12. Fig. 12 is a diagram schematically showing main components of a conventional hot-wall CVD apparatus. In Fig. 12, a substrate 10 is of single crystal and serves as a seed substrate for epitaxially growing SiC.

Further, a susceptor 20 is provided for mounting substrate 10 thereon, made of C (carbon) coated with SiC or TaC (tantalum carbide) or the like, and caused to heat up by high-frequency induction heating by means of a work coil 70 located below, and thereby heat substrate 10.

Furthermore, a heating plate 30 is placed opposite to susceptor 20, made similarly to susceptor 20, namely made of C coated with SiC or TaC or the like, and caused to heat up through high-frequency induction heating by a work coil 32 located above. Here, this apparatus is further provided with heat insulating materials 31, 60, shield plates (shields) 33, 71 made of stainless steel, cooling pipes 34, 72, a quartz pipe 80, an apparatus wall 90, a gas inlet 95, and a gas outlet 96.

Into the apparatus in which the temperature is set to 1500 to 1600°C and the vacuum is set to 13.3 to 26.6 kPa (100 to 200 Torr), a source gas of SiH₄ and C₃H₈ and a carrier gas of H₂ are introduced from gas inlet 95 and accordingly, on a surface of substrate 10 mounted on susceptor 20, SiC single crystal is epitaxially grown. After this, the gases are discharged from gas outlet 96 to the outside of the apparatus.

This hot-wall system, however, involves the following problems. Specifically, the introduced source gas forms the SiC single crystal on substrate 10, and also forms polycrystalline SiC on a surface of heating plate 30 which is placed opposite to substrate 10. The polycrystalline SiC formed on heating plate 30 forms particles that could fall on substrate 10 on which the SiC single crystal has been grown. If the SiC single crystal is mixed with the polycrystalline SiC, the quality of the SiC substrate will be degraded. It has therefore been necessary to regularly clean the inside of the apparatus for preventing the particles from falling.

Further, in the case where a plurality of substrates 10 are to be mounted on susceptor 20 with the aim of improving the production efficiency, if six substrates of around 50 mm (two inches) in diameter for example are to be disposed, a susceptor of a considerably large size is unnecessary. If, however, six substrates of around 150 mm (six inches) in diameter are to be disposed, a susceptor of a very large size is required. Such a susceptor having a large size also has a large surface area, which involves a further problem that heat is likely to be lost due to radiation and accordingly the energy cost is increased.

In order to overcome these problems, a technique has been disclosed (Japanese Patent Laying-Open No. 2008-311542 (PTL 1)). Specifically, a plurality of plates on which substrates are mounted are installed in multiple stages, so that the surface area of the susceptor per unit volume is reduced. Accordingly, efficient heating is performed with reduced heat loss, and the space is also saved. Further, the plates are arranged in such a manner that an upper plate extends more upstream of the gas flow than a lower plate. In this way, this technique prevents SiC particles from falling on the substrate and forms epitaxial films on many substrates.

A technique is also disclosed according to which a plurality of susceptors on which substrates are mounted are arranged in multiple stages and multiple sets of source gas inlets and outlets are provided in different directions, to thereby form epitaxial films on many substrates (Japanese Patent Laying-Open No. 2009-158726 (PTL 2)).

### CITATION LIST

### PATENT LITERATURE

PTL 1: Japanese Patent Laying-Open No. 2008-311542
PTL 2: Japanese Patent Laying-Open No. 2009-158726

### SUMMARY OF INVENTION

### TECHNICAL PROBLEM

Regarding the technique disclosed in Japanese Patent Laying-Open No. 2008-311542, however, a greater substrate size causes a difference between the composition of the upstream gas and the composition of the downstream gas, which results in a difference in the quality and the thickness and also a difference in the impurity concentration between the epitaxial films. Thus, products of a stable quality are difficult to obtain. Further, although this technique prevents adhesion of particles, it does not prevent generation itself of the particles.

Regarding the technique disclosed in Japanese Patent Laying-Open No. 2009-158726, while multiple sets of source gas inlets and outlets are provided, there is a limitation in the number of sets, and therefore, respective lengths of source gas paths cannot be made equal to each other. In addition, the gas flow is disturbed. Accordingly, uniform epitaxial films cannot be obtained. In the case where the source gas that has not been heated sufficiently arrives on each substrate, the temperature of the gas continues increasing even on the substrate, which causes a distribution of the epitaxial film thickness and a distribution of the impurity concentration, and accordingly uniform epitaxial films fail to be obtained.

Thus, there has been a demand for development of the technique of preventing particle generation and accordingly producing epitaxial films in high volume that are of excellent uniformity in the quality, the thickness and further the impurity concentration for example, while eliminating waste of energy.

### SOLUTION TO PROBLEM

A semiconductor thin-film manufacturing method of the present invention includes the following steps.

Substrates are mounted on a plurality of susceptors respectively. The plurality of susceptors on which the substrates are mounted respectively are placed on a rotational mechanism, so that the susceptors are vertically spaced at a predetermined interval. The rotational mechanism on which the plurality of susceptors are placed is rotated. The plurality of susceptors on which the substrates are mounted respectively are heated. Semiconductor thin-films are deposited by supplying a source gas to each of the susceptors that are heated while being rotated, the source gas having been heated while passing through gas flow paths of respective path lengths substantially equal to each other.

This manufacturing method uses a plurality of susceptors on which substrates are mounted to form a large number of semiconductor substrates (wafers) simultaneously, and thus can exhibit excellent mass productivity.

Further, since a plurality of susceptors are vertically spaced at a predetermined interval, waste of energy can be eliminated.

Furthermore, since the source gas having been heated to a temperature close to a predetermined film-deposition temperature while passing through gas flow paths of respective path lengths substantially equal to each other is introduced into each gap between the plurality of susceptors, the sufficiently-heated source gas is introduced under the same conditions to the susceptors regardless of the vertical position of the susceptor. Therefore, epitaxial films that are uniform in terms of the quality, the thickness, and further the impurity concentration can be formed on the substrates, regardless of the vertical position. Moreover, since the substrates are rotated by the rotational mechanism, the source gas introduced onto the susceptor can be distributed uniformly across the whole substrate surface. Consequently, epitaxial films can be formed that are excellent in uniformity of the thickness for example. The uniformity is achieved not only among the substrates but also within a substrate.

As to the multiple-stage arrangement, an example experiment was conducted by the inventors of the present invention. Specifically, in the case where a hydrogen-based gas of 100 slm was flown, the amount of heat was about 13 kW for a single susceptor arranged in a single stage, while the amount of heat was about 7 kW for susceptors arranged in multiple stages. Thus, it has been confirmed that the multiple-stage arrangement can reduce the amount of heat to approximately one half.

The source gas may be supplied in a form of a laminar flow to each of the plurality of susceptors.

The laminar flow of the source gas can be used to introduce to each susceptor the sufficiently-heated source gas under the same conditions regardless of the vertical position of the susceptor.

Specifically, a plurality of stationary rectifying plates provided at the same intervals as the intervals between the susceptors for example can be arranged immediately before the susceptors which are heated while being rotated, to allow the source gas to pass and thereby produce a laminar flow of the source gas.

The step of mounting substrates may include the step of placing the substrates on both sides respectively of at least one of a plurality of susceptors.

Since substrates (single-crystal substrates) are disposed on both sides respectively of the susceptor, the source gas flows between substrates opposite to each other, so that a uniform single-crystal film can be formed on each of the substrates. Consequently, polycrystal can be prevented from being formed on the susceptor and particle generation can be prevented. Since uniform single-crystal films can be formed respectively on both sides of the susceptor, the mass productivity is further enhanced.

At least one of: the plurality of susceptors; and the source gas, may be heated with radiant heat from a plurality of surfaces generated by resistance heating.

In the case where induction heating is employed as a heating method, if the rotational mechanism is introduced like the present invention, the symmetry of the path in which induction current flows is broken and induction heating is also performed asymmetrically. Therefore, a temperature distribution is generated and uniform heating fails to be performed. Moreover, induction current could flow in the rotational mechanism and partial over-heating could occur.

In contrast, the resistance heating method is heating by radiation from a heater. Therefore, these problems will not occur and uniform heating can easily be performed without temperature distribution. Further, heating is performed from at least two sides such as the upper side and the lower side, the asymmetry of the heat homogenizer plate which heats the susceptors can be compensated for to reduce the temperature distribution of the heat homogenizer plate.

The resistance heating may be performed by a plurality of resistance heaters controlled independently of each other.

Heating by the resistance heater can be performed while balancing the applied power based on independent temperature control to thereby compensate for the asymmetry of the heat loss from the rotational mechanism and perform uniform heating.

The above-described induction heating method requires a plurality of expensive power supplies for performing independent temperature control. Further, in the case where the induction heating method is used to perform heating from two sides, interference of high frequencies from the high-frequency coils occurs, and therefore, independent control is difficult to perform. The resistance heating method involves none of these problems.

At least one of: the plurality of susceptors; and the source gas may be heated by high-frequency heating. Thus, heating can be done in a short period and therefore the production efficiency of the semiconductor thin-films can be improved.

A plurality of susceptors each may have an outer periphery with a rotational peripheral velocity of not higher than a velocity of flow of the source gas supplied to the plurality of susceptors.

The rotational peripheral velocity of the outer periphery of the susceptors can be controlled so that it is equal to or lower than the velocity of flow of the source gas, and the source gas can be flown in the form of a laminar flow. Further, in the case where a stationary rectifying plate is provided before the susceptor, the stationary rectifying plate can keep the laminar flow of the source gas generated by the stationary rectifying plate. On the substrate, an epitaxial film can thus be formed that is excellent in uniformity of the thickness, quality, the impurity concentration and the like.

The step of placing the plurality of susceptors on the rotational mechanism may include the step of loading the plurality of susceptors into a chamber (55) containing the rotational mechanism. The plurality of susceptors may be unloaded after the step of depositing semiconductor thin-films. In each of the step of loading the plurality of susceptors and the step of unloading the plurality of susceptors, an ambient temperature in the chamber may be kept at not less than 200°C.

When the susceptors are loaded/unloaded in an ambient of a low temperature close to the room temperature, a temperature difference between an increased temperature and a decreased temperature causes thermal expansion and contraction based on which stress is generated. Accordingly, polycrystalline SiC for example that has adhered to the susceptor, the gas inlet and the rectifying plate for example other than the substrate peels off which could generate particles.

The ambient temperature can be kept at 200°C or more to prevent the adhering matter from peeling off and prevent particle generation. Further, at such a temperature, moisture does not adhere to the substrate. Therefore, particle generation due to the moisture can also be prevented. The ambient temperature is more preferably 300°C or more.

Since the above-described induction heating method is high-frequency heating, if the susceptor is moved while a high-frequency voltage is applied, high-frequency could be mismatched. Therefore, when the susceptor is to be removed, the high-frequency heating has to be rendered off. A constant temperature is thus difficult to keep. In contrast, in the case where resistance heating is used, a constant temperature can be kept by applying electrical energy.

The manufacturing method may further include the step of unloading the plurality of susceptors having a temperature of not less than 700°C, after the step of depositing semiconductor thin-films. Thus, the manufacturing efficiency of the semiconductor thin-films is further improved.

The step of depositing semiconductor thin-films may be performed by depositing one of silicon carbide and nitride.

Since the wide-bandgap semiconductors such as silicon carbide or nitride semiconductor have a large coupling energy, the source gas must be heated sufficiently for depositing a film of the semiconductor. In the present invention as described above, the source gas having been heated sufficiently can be supplied between rotating susceptors, which is suitable as a method for manufacturing these wide-bandgap semiconductors.

A semiconductor thin-film manufacturing apparatus of the present invention forms a semiconductor thin-film by supplying a source gas onto a substrate, and includes a plurality of susceptors, a rotational mechanism, a heating mechanism, and a source gas introduction mechanism. The plurality of susceptors (20-22) are mounted with substrates respectively. On the rotational mechanism, the plurality of susceptors are placed so that the susceptors are vertically spaced at a predetermined interval, and the rotational mechanism rotates the plurality of susceptors. The heating mechanism heats the plurality of susceptors each and the source gas to a predetermined temperature. The source gas introduction mechanism supplies, to the plurality of susceptors each, the source gas having been heated while passing through gas flow paths of respective path lengths substantially equal to each other.

The semiconductor thin-film manufacturing apparatus configured in the above-described manner can provide semiconductor in high volume on which respective epitaxial films are formed that are excellent in uniformity of characteristics such as quality, thickness, and impurity concentration, not only among the substrates but also within a substrate, as described above.

Further, since a plurality of susceptors are vertically spaced at a predetermined interval, heating can efficiently be performed with reduced energy waste, as described above, and the apparatus can be made compact.

The source gas introduction mechanism may include a laminar flow forming mechanism causing the source gas supplied to the plurality of susceptors each, to flow in a form of a laminar flow.

For example, a plurality of stationary rectifier plates provided at the same intervals as the intervals between the susceptors may be arranged immediately upstream of the susceptors which are heated while being rotated, to thereby form a laminar flow of the source gas. Accordingly, as described above, the sufficiently-heated source gas can be introduced under respective conditions identical to each other to the susceptors, regardless of the vertical position of the susceptor.

The heating mechanism may include a resistance heater. The resistance heater may be configured to be capable of emitting radiant heat from a plurality of surfaces.

The radiant heat from the resistance heater can be used to easily generate a uniform heating state without problems such as asymmetrical heating in the case where the induction heating method is used as described above.

The above-described manufacturing apparatus may further include a metal chamber and a heat insulating material. The chamber is water-cooled and contains the resistance heater. The heat insulating material is placed between the resistance heater and the chamber.

Since the resistance heater is contained in the water-cooled metal chamber, the chamber can be prevented from being heated and control of heating is facilitated. As a result, the safety can be improved. Further, the source gas can be prevented from leaking to thereby avoid waste of the source gas.

Since the resistance heater is contained with the heat insulating material between the chamber and the heater, heat from the resistance heater can be enclosed in a certain environment to thereby achieve efficient heating.

Further, the resistance heater with which the space can be saved is used, the heater is contained in the water-cooled metal chamber with the heat insulating material therebetween, and further, the rotational mechanism on which the susceptors are vertically arranged at predetermined intervals is employed. Thus, a more compact semiconductor thin-film manufacturing apparatus can be provided.

In the case of high-frequency heating (induction heating method), high frequency would be induced in the metal chamber. Therefore, the heating unit is difficult to be contained in the metal chamber. Thus, in this case, a quartz pipe or quartz window is generally used that is less safe than the water-cooled metal chamber.

The heating mechanism may be a high-frequency heating mechanism.

The above-described manufacturing apparatus may further include a rotational drive shaft for transmitting a drive force to the rotational mechanism. The rotational drive shaft may be made of carbon and have a diameter of not less than 5 mm and not more than 20 mm.

The above-described manufacturing apparatus may further include a lifting and lowering mechanism for lifting and lowering the plurality of susceptors.

A susceptor of the present invention is used for the above-described manufacturing apparatus, and includes a plate-shaped body and a latch protrusion. The plate-shaped body is provided with a hole (20b) formed so that the substrate can be mounted. The latch protrusion protrudes from the plate-shaped body toward the inside of the hole for preventing the substrate from dropping off the hole.

The susceptor of such a simple configuration can be used to easily arrange two substrates in one susceptor and simultaneously form upper and lower epitaxial films, and accordingly, the mass productivity is considerably improved.

Specifically, a first one of the substrates is first placed in the hole of the susceptor so that the front side of the first substrate faces downward. Then, the spacer is placed and further a second one of the substrates is placed so that the front side of the second substrate faces upward. At this time, the latch protrusions are provided in at least three locations along the lower inner wall surface of the susceptor, and therefore, these substrates and spacer will not drop off. The two substrates can thus be disposed.

A susceptor holder of the present invention is used for the rotational mechanism of the semiconductor thin-film manufacturing apparatus described above. The susceptor holder holds the plurality of susceptors each in such a manner that the plurality of susceptors are vertically spaced at a predetermined interval. A protrusion is provided on a head of the susceptor holder so that the protrusion can be used for loading and unloading a plurality of susceptors.

While all susceptors are held vertically at predetermined intervals, the susceptors are uniformly rotated. Accordingly, semiconductor films without dispersion of features such as thickness can be formed on each of the substrates placed in the susceptors.

Further, in this state, the susceptors can be loaded and unloaded. Therefore, the susceptors can be loaded and unloaded easily at an ambient temperature of 200°C or more as described above. Specifically, a T-shaped protrusion is provided on the head of the susceptor holder, and an arm holds this protrusion therein to load and unload the susceptors.

### ADVANTAGEOUS EFFECTS OF INVENTION

The present invention can prevent particle generation and thus manufacture, with a compact apparatus, epitaxial films in high volume that have excellent uniformity in terms of characteristics such as quality, thickness, and impurity concentration, not only among the substrates but also within a substrate, while eliminating waste of the energy and the source gas.

### BRIEF DESCRIPTION OF DRAWINGS

Fig. 1 is a cross section generally and schematically showing a semiconductor thin-film manufacturing apparatus in a first embodiment of the present invention.
Fig. 2 is a diagram schematically showing a chamber and its vicinity of the semiconductor thin-film manufacturing apparatus in the first embodiment of the present invention.
Fig. 3 shows a diagram (A) schematically illustrating main components of the chamber of the semiconductor thin-film manufacturing apparatus in the first embodiment of the present invention, and an enlarged view (B) of a part of the diagram.
Fig. 4 is a diagram conceptually showing a state where a source gas is uniformly supplied.
Fig. 5 is a diagram schematically illustrating introduction of a source gas to susceptors of the semiconductor thin-film manufacturing apparatus in the first embodiment of the present invention.
Fig. 6 shows an exploded perspective view (A) generally and schematically showing an example intermediate susceptor of the semiconductor thin-film manufacturing apparatus in the first embodiment of the present invention, and a cross section (B) of the susceptor.
Fig. 7 shows an exploded perspective view (A) generally and schematically showing another example intermediate susceptor of the semiconductor thin-film manufacturing apparatus in the first embodiment of the present invention, and a cross section (B) of the susceptor.
Fig. 8 is a perspective view generally and schematically showing the lowermost susceptor of the semiconductor thin-film manufacturing apparatus in the first embodiment of the present invention.
Fig. 9 is provided for illustrating the effects of substrate rotations and source-gas preheating, and shows a graph (A) illustrating an example relation between the distance in the flow direction of the source gas and the thickness of the semiconductor thin-film, and a graph (B) illustrating an example relation between the distance in the flow direction of the source gas and the temperature of the source gas.
Fig. 10 is a partial cross section generally and schematically showing a semiconductor thin-film manufacturing apparatus in a second embodiment of the present invention.
Fig. 11 is a perspective view generally showing a high-frequency heating unit in Fig. 10 and its vicinity.
Fig. 12 is a diagram showing a state where SiC semiconductor substrates of a comparative example are manufactured.

### DESCRIPTION OF EMBODIMENTS

In the following, the present invention will be described specifically based on embodiments.

### First Embodiment

### 1. Semiconductor thin-film manufacturing apparatus

### (1) Overall configuration

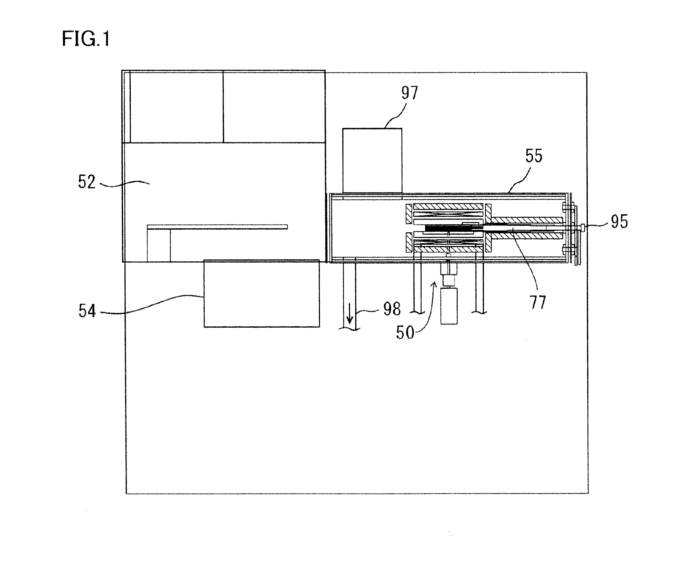

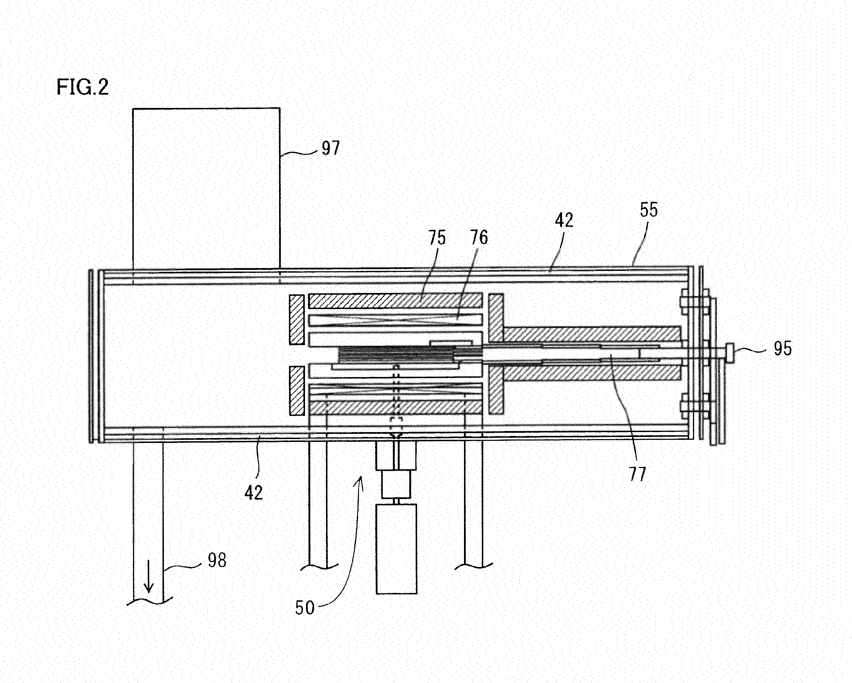

First, the whole of a CVD apparatus (hereinafter also referred to as "apparatus") provided as a semiconductor thin-film manufacturing apparatus in the present embodiment will be described using Figs. 1 and 2. Here, Fig. 1 is a cross section generally and schematically showing the semiconductor thin-film manufacturing apparatus in the present embodiment, and Fig. 2 is a diagram schematically showing a chamber and its vicinity that is a main component of the semiconductor thin-film manufacturing apparatus.

As shown in Figs. 1 and 2, the semiconductor thin-film manufacturing apparatus in the present embodiment includes a chamber 55 made of SUS, a rotational mechanism 50 for rotating substrates, a gas inlet 95 from which a source gas is introduced, a preheating unit 77 heating the source gas in advance, a turbo-molecular pump 97 and an exhaust duct 98 for exhausting gas, and a glove box 52 and a pass box 54 for removing epitaxially-grown substrates.

Preheating unit 77 is designed to have a predetermined length so that the introduced gas is uniformly and sufficiently heated. Further, in order to introduce the source gas under the same conditions to respective spaces between the susceptors, the preheating unit is designed to have a larger cross section than a set of susceptors disposed in the vertical direction and fixed by a susceptor holder.

In chamber 55 in which a water cooling jacket 42 is provided along the top and bottom inner wall, a heater 76 of the resistance heating type surrounded with a heat insulating material 75 formed of carbon felt is provided. A susceptor is set between two heaters 76 provided above and below the susceptor respectively.

### (2) Chamber

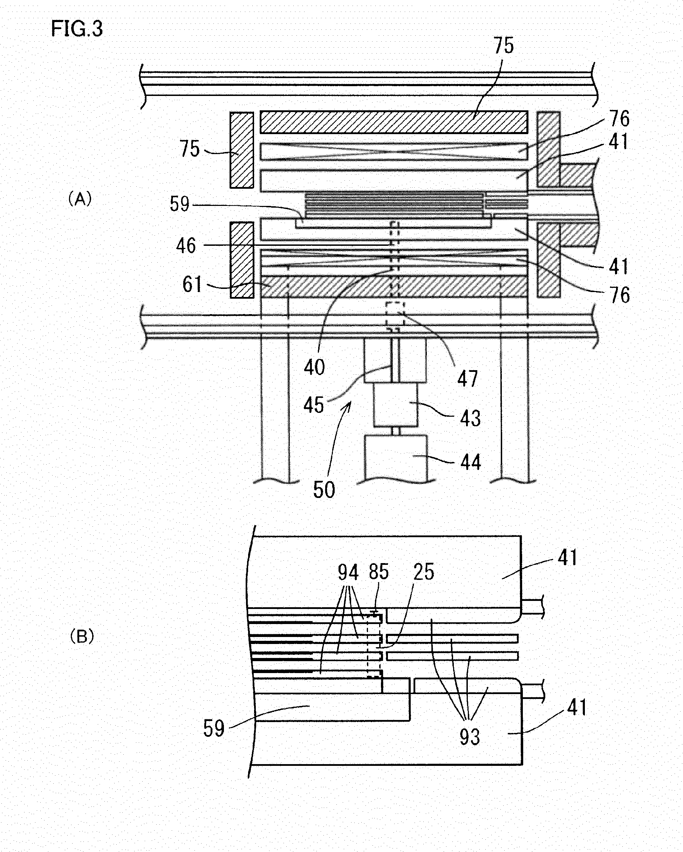

Next, a configuration in chamber 55 will be described using Fig. 3 (A) and Fig. 3 (B). Fig. 3 (A) and Fig. 3 (B) schematically show main components of the chamber.

As shown in Fig. 3 (A), heat homogenizer plates 41 are provided so that each plate contacts heater 76 surrounded with heat insulating material 75. Lower heat homogenizer plate 41 is provided with a rotational plate 59. On rotational plate 59, susceptors are arranged. Rotational plate 59 is connected to a rotational shaft 46 of rotational mechanism 50. Rotational shaft 46 has an upper part formed of a carbon rod 40, is connected via a quartz joint 47 to a shaft 45 made of SUS, and further connected to a motor 44 via a magnetic fluid seal 43. Namely as motor 44 rotates, rotational plate 59 rotates via magnetic fluid seal 43.

The susceptor also serves as a rotational rectifier plate 94, and is placed in the vicinity of a stationary rectifier plate 93 in such a manner that the rotational rectifier plate and the stationary rectifier plate form the same horizontal plane. This state is shown in Fig. 3 (B). The rectifier plates generate a laminar flow of the introduced source gas, and this source gas of substantially the same temperature is uniformly introduced to each susceptor. Rotational rectifier plates 94 (susceptors) are secured to each other by a susceptor holder 25 so that they rotate together as a set of susceptors.

Thus, susceptor holder 25 is used for rotational mechanism 50. Susceptor holder 25 holds each of a plurality of susceptors (rotational rectifier plates 94) so that the susceptors are vertically spaced at predetermined intervals. Susceptor holder 25 has its head provided with a protrusion 85 so that it can be used for loading and unloading a plurality of susceptors.

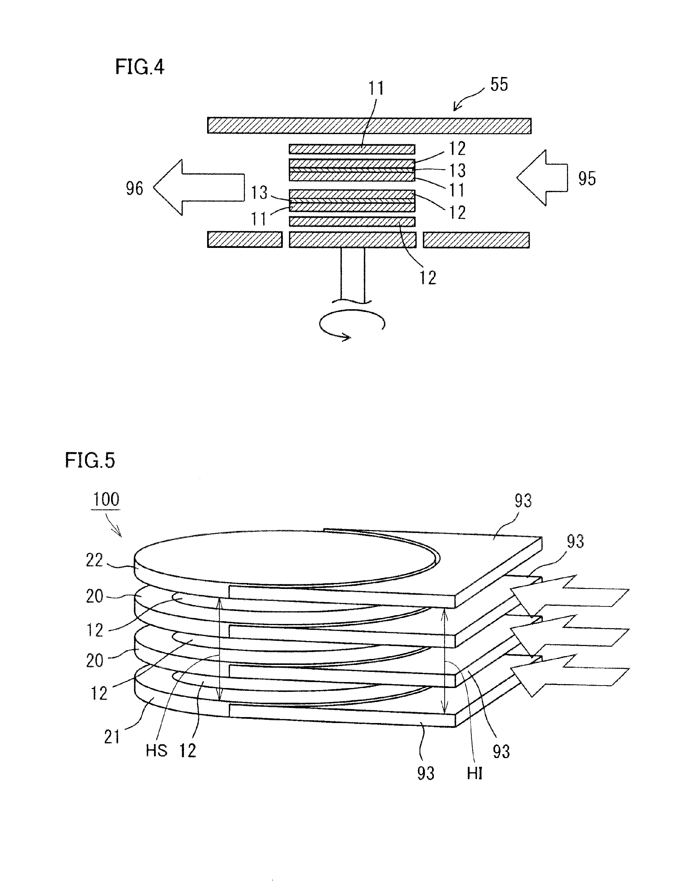

Fig. 4 conceptually shows the state where the source gas is uniformly supplied. In Fig. 4, except for the top and bottom substrates, substrates 11,12 are placed on one susceptor with a spacer 13 therebetween. Since the source gas is introduced from gas inlet 95 through the long preheating unit (not shown) to each space between the susceptors under the same conditions such as temperature and velocity of flow, epitaxial films are formed respectively on the substrates under the same conditions. Further, since the susceptors are rotating, the source gas can uniformly be distributed over the whole surface of each substrate. As a result, the epitaxial films can be formed that are excellent in uniformity in characteristics such as thickness, quality, and impurity concentration. The uniformity is exhibited not only among the substrates but also within each substrate.

Further, as shown in Fig. 3 (B), since stationary rectifier plate 93 is provided before each susceptor, the source gas in the form of a laminar flow is introduced to each susceptor. Accordingly, the epitaxial films that are more excellent in uniformity can be formed.

### (3) Susceptor

Next, the susceptor will be described using Figs. 5, 6 (A), 6 (B), 7 (A), and 7 (B).

Fig. 5 is a diagram schematically illustrating introduction of the source gas to the susceptors, and corresponds to the conceptual diagram of Fig. 4. In the manufacturing apparatus of the present embodiment, the flow of the source gas is controlled by a rectifier unit 100. Rectifier unit 100 includes susceptors 20 to 22 and a plurality of stationary rectifier plates 93. To susceptors 20 to 22 that are rotating with substrates 12 placed thereon, the source gas is introduced via stationary rectifier plates 93, and a single crystal is epitaxially grown on the substrate placed in each susceptor. In Fig. 5, as to intermediate susceptor 20, two substrates, namely upper and lower substrates are placed in the susceptor. As to lowermost susceptor 21, only its upper surface has a substrate placed thereon. As to uppermost susceptor 22, only its lower surface has a substrate placed thereon.

A plurality of stationary rectifier plates 93 are arranged correspondingly to susceptors 20 to 22, respectively. A height HS of the space between susceptors 21 and 22 is almost equal to a height HI of the space between the lowermost stationary rectifier plate 93 and the uppermost stationary rectifier plate 93. For example, height HI is within ±10% of height HS.

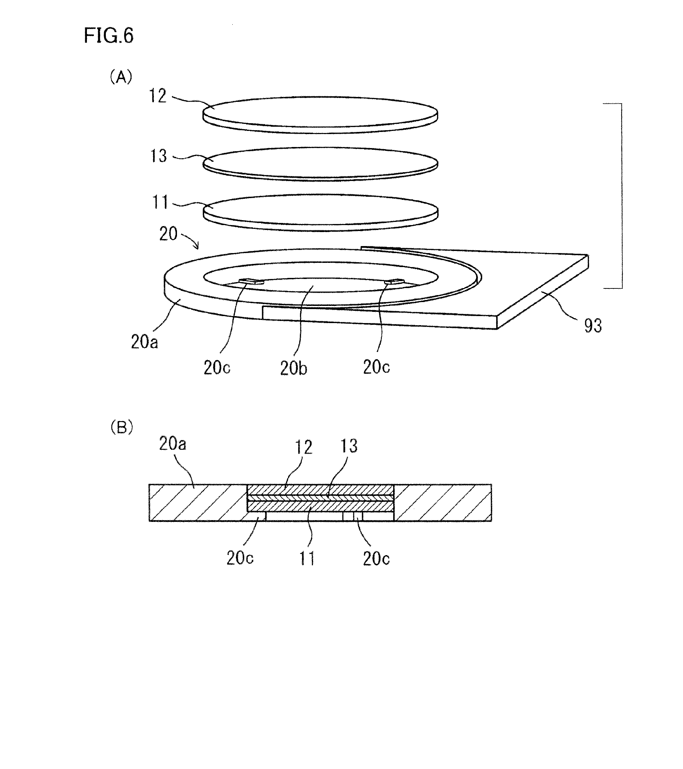

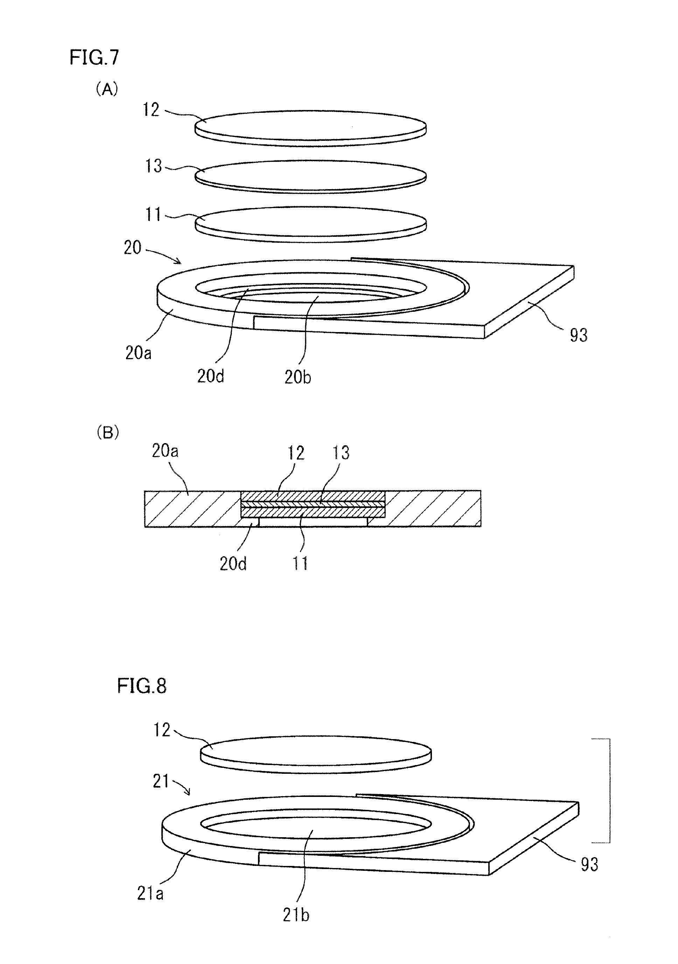

Next, in Fig. 6 (A) and Fig. 6 (B), a perspective view and a cross section generally showing intermediate susceptor 20 are given respectively. As shown in Fig. 6 (A) and Fig. 6 (B), intermediate susceptor 20 includes a disklike susceptor body 20a having a predetermined thickness. In susceptor body 20a, a hole 20b is formed for setting substrates 11, 12 therein. Latch protrusions 20c protruding from body 20a toward the inside of hole 20b are provided in at least three locations respectively. Here, as shown in Fig. 7 (A) and Fig. 7 (B), latch protrusion 20c may also be provided in the form of a ring along the whole inner circumference of the lower part of susceptor body 20a.

In hole 20b of horizontally-set susceptor 20, a first substrate 11 is placed so that the front side of the substrate faces downward. Then, spacer 13 is placed on substrate 11, and a second substrate 12 is further placed on the spacer so that the front side of the substrate faces upward. The material for spacer 13 is preferably the same as the material for the susceptor, and the thickness of spacer 13 is defined so that the sum of the thickness of the spacer and respective thicknesses of the two substrates is equal to the thickness of the susceptor. In this way, each substrate surface and the corresponding susceptor surface can be laid in the same plane.

Since hole 20b in which the substrates are set is provided with latch protrusions 20c at three or more locations, the two substrates will not fall even when the susceptor is lifted.

How a substrate is set in lowermost susceptor 21 is shown in Fig. 8. Since the lower surface of lowermost susceptor 21 abuts on the rotational plate, only one substrate is set here. In the upper surface of susceptor 21, a counter bore 21b is provided instead of through hole 20b (Fig. 6 (A)). In the lower surface of susceptor 22 as well, a similar counter bore is provided.

### 2. Manufacture (epitaxial growth) of semiconductor thin-film on substrate

Next, a description will be given of manufacture (epitaxial growth) of a semiconductor thin film using the above-described apparatus.

Initially, two substrates are set in each susceptor (one substrate in an uppermost/lowermost susceptor). A plurality of susceptors in which the substrates are set are fixed at predetermined intervals in the vertical direction by means of the susceptor holder (a set of susceptors), and thereafter the susceptors are transported into the chamber and attached to the rotational plate.

Next, the turbo-molecular pump is used to exhaust a residual gas in the chamber, the glove box, and the pass box so that a high vacuum is generated therein.

Then, while the set of susceptors is rotated by the rotational mechanism, the inside of the chamber is heated to a predetermined temperature by the heaters.

After this, a source gas is introduced from the gas inlet into the chamber. At this time, the source gas has sufficiently been heated in advance by the preheating unit. After the source gas is flown, a dry pump is used instead of the turbo-molecular pump to exhaust the gas from the exhaust duct.

The heated source gas is introduced via the stationary rectifier plates to the rotational rectifier plates (susceptors). At this time, since the preheating unit is designed so that it has a greater size than the set of susceptors, the source gas is introduced to each stationary rectifier plate and each susceptor under the same conditions. Further, since the source gas is fed through the stationary rectifier plates, the source gas flows in the form of a laminar flow. The rotational peripheral velocity of the outer periphery of the susceptor is controlled so that the velocity is equal to or lower than the velocity of flow of the source gas. Accordingly, the laminar flow of the source gas is not disturbed and flows between the rotating susceptors.

The uniform source gas thus introduced allows a single crystal to epitaxially grow on each substrate that is excellent in uniformity of characteristics such as film quality, film thickness, and impurity concentration.

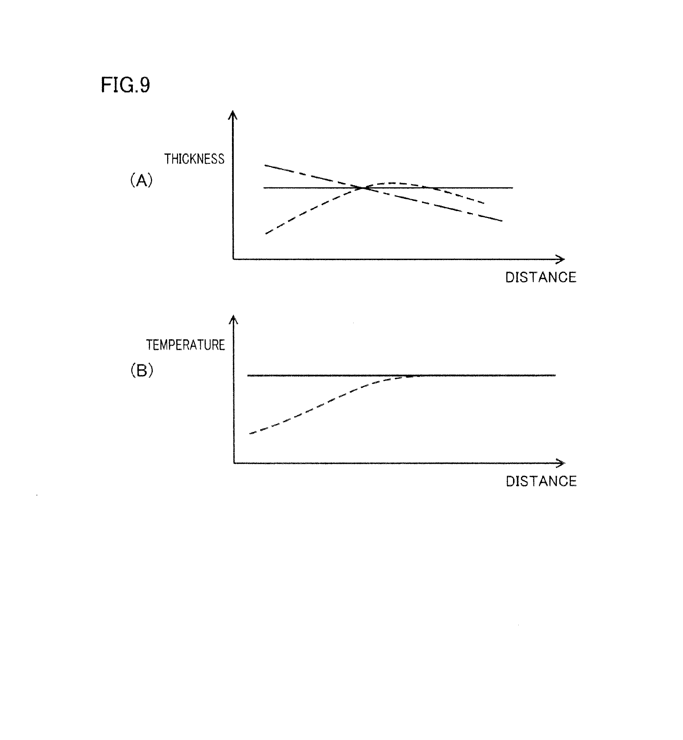

Here, as to an influence of the heating state of the source gas on the film thickness, a description will be given based on Fig. 9 (A) and Fig. 9 (B). In Fig. 9 (A) and Fig. 9 (B) each, the horizontal axis represents the position along the direction of the flow of the source gas. The vertical axis in Fig. 9 (A) represents the thickness of a semiconductor thin-film formed on a substrate, and the vertical axis in Fig. 9 (B) represents the gas temperature on the substrate.

In the case where the gas has been heated sufficiently, the gas of a constant temperature is introduced onto the substrate as indicated by the solid line in Fig. 9 (B). As for the film thickness in this case, the thickness gradually decreases as the gas is consumed if the substrate is not rotated, as indicated by the alternate long and short dash line in Fig. 9 (A). In the case where the substrate is rotated, the film with a uniform thickness is deposited as indicated by the solid line in Fig. 9 (A).

In contrast, in the case where the gas has not been heated sufficiently, the film of a sufficient thickness cannot be deposited initially even if the substrate is rotated, as indicated by the broken line in Fig. 9 (B). In the region of the edge and its vicinity of the substrate, the thickness of the film also decreases as the gas is consumed.

After a single-crystal film of a predetermined thickness is formed, the set of susceptors is unloaded at a temperature of 200°C or more into the glove box of an inert gas ambient such as Ar gas. The susceptor set is unloaded at a high temperature to thereby prevent moisture from adhering to components such as susceptor, heater, and heat homogenizer plate, and enable subsequent high-purity epitaxial films to be formed. Further, since the rate of decrease of the temperature from around 200°C is smaller, the susceptor set can be unloaded and the subsequent susceptor set can be loaded at such a high temperature to thereby increase the throughput of the apparatus.

Further, the temperature in the chamber is not lowered to a temperature close to the room temperature, to thereby enable particles from being generated due to peeling of adhering matters caused by a temperature change.

The susceptor set having been unloaded at a high temperature is cooled in the glove box to the room temperature. After this, the set is let fall in the pass box and removed so that the atmosphere does not enter the glove box.

In each of the manufacture steps described above, the heaters are thermally insulated by the carbon-felt heat insulating material, and therefore, the heat loss is small in each step. Further, since the components to be heated are surrounded with the water cooling jacket, the apparatus can be downsized. Moreover, the temperature increase in the room in which the apparatus is installed can be made minimum.

In accordance with the present embodiment, while the source gas is heated to a temperature close to the susceptor temperature before reaching the group of substrates, the source gas is fed through the flow paths to respective substrates, and the flow paths have respective lengths substantially equal to each other. Thus, the dispersion of respective temperatures of the source gas when it reaches respective substrates is small. In this way, the dispersion of respective film-deposition conditions for the substrates can be reduced.

Here, the fact that respective lengths of the paths of the source gas are substantially equal to each other specifically means that the path lengths are substantially equal to each other in terms of heating of the source gas, and corresponds for example to the fact that the dispersion of respective path lengths for the substrates is within ±10% relative to a certain value.

### Second Embodiment

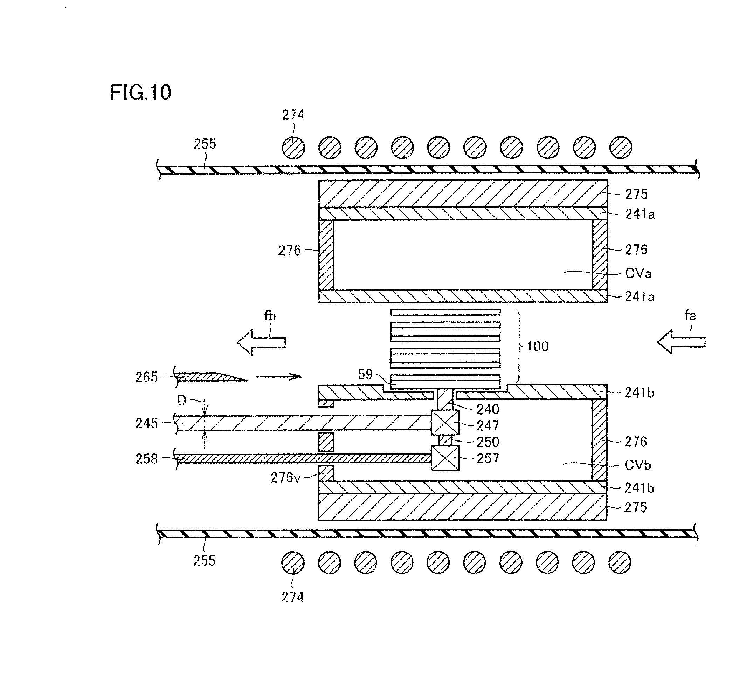

Referring to Figs. 10 and 11, a semiconductor thin-film manufacturing apparatus in the present embodiment includes a quartz pipe 255 (chamber), a high-frequency coil 274, heat insulating materials 275, 276, and 276v, a carbon rod 240, high-frequency heating units 241a and 241 b, a rotational drive shaft 245, a rotational direction changing unit 247, a transport arm 265, and a lifting and lowering mechanism 257. Lifting and lowering mechanism 257 has a control rod 258 and a displacement rod 250.

Rotational drive shaft 245 is made of carbon and may have a diameter D of not less than 5 mm and not more than 20 mm. Rotational drive shaft 245 is rotated about its axis to transmit a drive force. The drive force transmitted by rotational drive shaft 245 is changed in its rotational direction by rotational direction changing unit 247 into a rotational force of carbon rod 240 functioning as a rotational mechanism.

In the present embodiment, susceptors 20 to 22 and a plurality of stationary rectifier plates 93 (Fig. 5) that are included in rectifier unit 100 are heated through high-frequency heating. Further, a plurality of stationary rectifier plates 93 are heated and accordingly the source gas flowing between the plates is heated. The source gas introduced as indicated by an arrow fa is heated to be used for depositing a film, and thereafter discharged as indicated by an arrow fb. The high-frequency heating is performed specifically by means of induction current generated, by high-frequency coil 274, in each of high-frequency heating units 241a and 241 b. The induction current flows in such a manner that it circulates in each of a hollow portion CVa of high-frequency heating unit 241a and a hollow portion CVb of high-frequency heating unit 241b along respective peripheries (see the arrows in Fig. 11).

At the time immediately after the semiconductor thin-film is deposited by heating and supply of the source gas as described above, susceptors 20 to 22 have a high temperature. In the present embodiment, after the semiconductor thin-film is deposited, susceptors 20 to 22 having a temperature of 700°C or more may be unloaded. Specifically, lifting and lowering mechanism 257 first pushes carbon rod 240 upward. Accordingly, rotational plate 59 is raised and consequently susceptors 20 to 22 are lifted. Next, transport arm 265 is moved as indicated by the arrow (Fig. 10) to be inserted below rotational plate 59. Subsequently, push-up of carbon rod 240 by lifting and lowering mechanism 257 is cancelled, and accordingly susceptors 20 to 22 and rotational plate 59 move down to be mounted on transport arm 265. Then, transport arm 265 is shifted to thereby unload susceptors 20 to 22 on which the substrates are mounted, together with rotational plate 59. Preferably, they are unloaded downstream (in the direction indicated by arrow fb) of the flow of the source gas.

As described above, lifting and lowering mechanism 257 is provided for lifting and lowering susceptors 20 to 22 to thereby enable transport arm 265 to be inserted below susceptors 20 to 22 and thus enable unloading by means of transport arm 265.

Here, the characteristics other than the above-described ones are substantially identical to those of the above-described first embodiment. Therefore, the same or corresponding components are denoted by the same reference characters, and the description thereof will not be repeated.

In accordance with the present embodiment, high-frequency heating can be used to perform heating in a shorter period of time. In this way, the manufacturing efficiency of semiconductor thin-films can be enhanced.

Further, lifting and lowering mechanism 257 can be provided to facilitate unloading of susceptors 20 to 22. Therefore, susceptors 20 to 22 can be unloaded even when the temperature of susceptors 20 to 22 is approximately 1000°C. For example, they may be unloaded at 700°C or more for example to further enhance the manufacturing efficiency.

### Examples

An Example corresponding to the above-described first embodiment will be illustrated below. In this Example, the above-described apparatus was used to form single-crystal SiC films on six SiC substrates at the same time.

An ingot grown by the modified Lely method was cut, mirror-polished, thereafter subjected to cleaning successively with an organic solvent, namely the so-called RCA cleaning, and hydrofluoric acid and thereafter rinsed with deionized water, to produce six 4H-SiC{0001} substrates (150 mm in diameter × 600 µm in thickness). The substrates were set on susceptors. Here, the resistance of the substrates was 0.017 Ωcm.

The susceptors are each formed of a TaC-coated carbon plate (200 mm in diameter × 2 mm in thickness), and a hole is provided in a central portion of each susceptor for placing the substrate in the hole. Along the periphery of the hole, latch protrusions extending inward are provided at three locations.

Two substrates are placed in a susceptor in the following manner. First, a first one of the substrates is placed in the hole of the susceptor so that the front side of the substrate faces downward. Then, on the first substrate, a TaC-coated disk (1 mm in thickness) is placed to serve as a spacer. Finally, the second substrate is placed on the spacer so that the front side of the substrate faces upward. Thus, the sum of respective thicknesses of the two substrates and the spacer can be made equal to the thickness of the susceptor. As described above, since the protrusions are provided in the hole of the susceptor, these substrates and spacer will not drop off. In this way, two substrates are placed in one susceptor to thereby enable SiC films to be formed simultaneously on the two substrates, namely the upper and lower substrates.

Three susceptors in which the six substrates in total were accommodated were arranged vertically at regular intervals on the rotational mechanism, and heated to 1550°C by resistance heaters provided on the two sides, namely upper and lower sides.

As a source gas to be introduced, a gas mixture of H₂, SiH₄, C₃H₈, and N₂ was used. The gas was introduced at respective flow rates of H₂ = 150 slm, SiH₄ = 45 sccm, C₃H₈ = 22.5 sccm, and N₂ = 80 sccm, and the pressure was kept at 10 kPa (100 mbar).

The rotational speed of the susceptors was set to 100 rpm so that it was equal to or lower than the velocity of flow of the source gas.

Under the above conditions, SiC single-crystal films each having a thickness of 11 µm were formed on the six substrates in a growth time of 120 minutes.

The dispersion of respective thicknesses of the six substrates on which the SiC single-crystal films were formed was measured. The dispersion of the thicknesses measured at the center was (maximum-minimum)/average < 3%. The impurity concentration at the center was also measured. The average carrier density was 9×10¹⁵ cm⁻², and the dispersion of the densities was (maximum-minimum)/average < 5%.

The dispersion of measurements within a substrate was also measured. The dispersion in thickness was (maximum-minimum)/average < 3% and the dispersion in impurity concentration was (maximum-minimum)/average < 4%.

As described above, the six SiC single-crystal substrates with a small dispersion could be obtained. The reason for this is considered to be that the single crystal was epitaxially grown on the six substrates under respective conditions substantially identical to each other. Specifically, the dispersion of respective temperatures of the substrates and the dispersion of respective temperatures of the source gas at the time the source gas reached the substrates were each small. The reason why the dispersion of respective temperatures of the substrates was reduced is considered to be that each substrate was attached to the susceptor. The reason why the dispersion of the temperatures of the source gas was reduced is considered to be that, while the source gas was heated to a temperature close to the susceptor temperature before reaching the group of substrates, the lengths of the paths of the source gas supplied to the substrates were substantially equal to each other.

As to measurement of the thickness of each substrate, five points were selected that were located inside by 7 mm from the outer periphery of the substrate of 150 mm in diameter on which the SiC single-crystal film had been formed. The impurity concentration of each substrate was measured by the C-V measurement method.

The average density of particle detects of the six wafers that were generated in the process of epitaxial growth was 0.4 cm*⁻².* Here, the particle detects refer to detects of an epitaxially grown film due to particles. The defects of the epitaxially grown film were observed as protrusions by an optical microscope with a magnification of x500. The number of defects each having a size of approximately 1 µm × 1 µm or more, or a diameter of 1 µm or more was counted in the whole of the substrate, and the number was converted into the number per square centimeter.

After this, the SiC epitaxial film obtained in this Example was used, a Ti Schottky electrode of 2.4 mm in diameter was formed on the front side, an Ni ohmic electrode was formed on the rear side, and accordingly a Schottky diode was produced. Around the Schottky electrode, Al ions were implanted to form a triple guard ring. This Schottky diode had a breakdown voltage of 1200 V and an ON voltage for 500 A/cm² of 1.7 V, and it was thus confirmed that the Schottky diode had excellent characteristics.

### Comparative Example

In the present Comparative Example, an SiC single crystal was epitaxially grown on a substrate by the hot-wall system.

The apparatus shown in Fig. 12 was used to grow an SiC single crystal on a substrate to thereby produce the SiC substrate of the Comparative Example. For this apparatus, the high-frequency induction heating method was employed as the heating method as described above. Further, the substrates were not vertically arranged in multiple stages but arranged in the same plane.

In this Comparative Example, rotation was not done. This is for the reason that the susceptor was surrounded by high-frequency coils and thus rotations were difficult to be effected from below.

The height of a channel in which a gas flows was set to be identical to the distance between heat homogenizer plates or the distance between the rectifier plates in the Example. Other conditions were identical to those of the Example and an SiC single-crystal film of 12 µm in thickness was formed.

In this Comparative Example, the growth rate is higher than the Example by a little less than 10%. In the Comparative Example, however, the same gas consumption as the Example can be used to grow only one epitaxial layer on the upstream side and only one epitaxial layer on the downstream side. Therefore, the productivity of the Comparative Example is approximately one third that of the Example. Further, in the Comparative Example, the difference in film thickness between the upstream side and the downstream side was 10% and the difference in impurity concentration therebetween was 20%. As to particle defects, polycrystalline SiC assumed to fall from heating plate 30 adhered to the substrate, and the average density of the defects was 5 cm⁻².

It should be construed that embodiments and examples disclosed herein are by way of illustration in all respects, not by way of limitation. It is intended that the scope of the present invention is defined by claims, not by the description above, and encompasses all modifications and variations equivalent in meaning and scope to the claims.

### REFERENCE SIGNS LIST

10, 11, 12 substrate; 13 spacer; 20-22 susceptor; 20a susceptor body; 20b hole; 20c, 20d latch protrusion; 25 susceptor holder; 30 heating plate; 32, 70 work coil; 31, 60, 75 heat insulating material; 33, 71 shield plate (shield); 34, 72 cooling pipe; 40 carbon rod; 41 heat homogenizer plate; 42 water cooling jacket; 43 magnetic fluid seal; 44 motor; 45 shaft; 46 rotational shaft; 47 quartz joint; 50, 240 rotational mechanism; 52 glove box; 54 pass box; 55 chamber; 59 rotational plate; 76 heater; 77 preheating unit; 85 protrusion; 93 stationary rectifier plate; 94 rotational rectifier plate; 95 gas inlet; 96 gas outlet; 97 turbo-molecular pump; 98 exhaust duct; 245 rotational drive shaft; 257 lifting and lowering mechanism

## Claims

1. A semiconductor thin-film manufacturing method comprising the steps of:
mounting substrates (10-12) on a plurality of susceptors (20-22) respectively;
placing, on a rotational mechanism (50), said plurality of susceptors on which said substrates are mounted respectively, so that said susceptors are vertically spaced at a predetermined interval;
rotating said rotational mechanism (50) on which said plurality of susceptors are placed;
heating said plurality of susceptors on which said substrates are mounted respectively; and
depositing semiconductor thin-films by supplying a source gas to each of said susceptors that are heated while being rotated, said source gas having been heated while passing through gas flow paths of respective path lengths substantially equal to each other.

2. The semiconductor thin-film manufacturing method according to claim 1, wherein said source gas is supplied in a form of a laminar flow to each of said plurality of susceptors.

3. The semiconductor thin-film manufacturing method according to claim 1, wherein said step of mounting substrates includes the step of placing said substrates on both sides respectively of at least one of said plurality of susceptors.

4. The semiconductor thin-film manufacturing method according to claim 1, wherein at least one of
said plurality of susceptors and
said source gas
is heated with radiant heat from a plurality of surfaces generated by resistance heating.

5. The semiconductor thin-film manufacturing method according to claim 4, wherein said resistance heating is performed by a plurality of resistance heaters (76) controlled independently of each other.

6. The semiconductor thin-film manufacturing method according to claim 1, wherein at least one of
said plurality of susceptors and
said source gas
is heated by high-frequency heating.

7. The semiconductor thin-film manufacturing method according to claim 1, wherein said plurality of susceptors each have an outer periphery with a rotational peripheral velocity of not higher than a velocity of flow of said source gas supplied to said plurality of susceptors.

8. The semiconductor thin-film manufacturing method according to claim 1, wherein
said step of placing said plurality of susceptors on said rotational mechanism includes the step of loading said plurality of susceptors into a chamber (55) containing said rotational mechanism,
said method further comprises the step of unloading said plurality of susceptors after said step of depositing semiconductor thin-films, and
in each of said step of loading said plurality of susceptors and said step of unloading said plurality of susceptors, an ambient temperature in said chamber is kept at not less than 200°C.

9. The semiconductor thin-film manufacturing method according to claim 1, further comprising the step of unloading said plurality of susceptors having a temperature of not less than 700°C, after said step of depositing semiconductor thin-films.

10. The semiconductor thin-film manufacturing method according to claim 1, wherein said step of depositing semiconductor thin-films is performed by depositing one of silicon carbide and nitride.

11. A semiconductor thin-film manufacturing apparatus forming a semiconductor thin-film by supplying a source gas onto a substrate (10-12), said apparatus comprising:
a plurality of susceptors (20-22) on which said substrates are mounted respectively;
a rotational mechanism (50) on which said plurality of susceptors are placed so that said susceptors are vertically spaced at a predetermined interval, and which rotates said plurality of susceptors;
a heating mechanism heating said plurality of susceptors each and said source gas to a predetermined temperature; and
a source gas introduction mechanism supplying, to said plurality of susceptors each, said source gas having been heated while passing through gas flow paths of respective path lengths substantially equal to each other.

12. The semiconductor thin-film manufacturing apparatus according to claim 11, wherein said source gas introduction mechanism includes a laminar flow forming mechanism causing said source gas supplied to said plurality of susceptors each, to flow in a form of a laminar flow.

13. The semiconductor thin-film manufacturing apparatus according to claim 11, wherein said heating mechanism includes a resistance heater (76), and said resistance heater is configured to be capable of emitting radiant heat from a plurality of surfaces.

14. The semiconductor thin-film manufacturing apparatus according to claim 13, further comprising:
a metal chamber (55) which is water-cooled and contains said resistance heater; and
a heat insulating material (75) placed between said resistance heater and said chamber.

15. The semiconductor thin-film manufacturing apparatus according to claim 11, wherein said heating mechanism is a high-frequency heating mechanism.

16. The semiconductor thin-film manufacturing apparatus according to claim 11, further comprising a rotational drive shaft (245) for transmitting a drive force to said rotational mechanism (240), said rotational drive shaft being made of carbon and having a diameter of not less than 5 mm and not more than 20 mm.

17. The semiconductor thin-film manufacturing apparatus according to claim 11, further comprising a lifting and lowering mechanism (257) for lifting and lowering said plurality of susceptors.

18. A susceptor (20) used for the semiconductor thin-film manufacturing apparatus as recited in claim 11, said susceptor comprising:
a plate-shaped body (20a) provided with a hole (20b) formed so that said substrate can be mounted; and
a latch protrusion (20c) protruding from said plate-shaped body toward the inside of said hole for preventing said substrate from dropping off said hole.

19. A susceptor holder (25) used for the rotational mechanism of the semiconductor thin-film manufacturing apparatus as recited in claim 11,
said susceptor holder holding said plurality of susceptors each in such a manner that said plurality of susceptors are vertically spaced at a predetermined interval, and
a protrusion (85) being provided on a head of said susceptor holder so that said protrusion can be used for loading and unloading said plurality of susceptors.
